# EUROPÄISCHE PATENTSCHRIFT

(11) **EP 1 488 468 B1**
(45) Veröffentlichungstag und Bekanntmachung des Hinweises auf die Patenterteilung: **27.09.2006**
(21) Anmeldenummer: 03722235.3
(22) Anmeldetag: 27.03.2003
(51) Int. Cl.: H01L 51/52, H01L 51/50

(54) **TRANSPARENTES, THERMISCH STABILES LICHTEMITTIERENDES BAUELEMENT MIT ORGANISCHEN SCHICHTEN**
TRANSPARENT, THERMALLY STABLE LIGHT-EMITTING COMPONENT COMPRISING ORGANIC LAYERS
COMPOSANT LUMINESCENT TRANSPARENT, THERMIQUEMENT STABLE, POURVU DE COUCHES ORGANIQUES

(30) Priorität: 28.03.2002 DE 10215210
(43) Veröffentlichungstag der Anmeldung: 22.12.2004
(73) Patentinhaber: Novaled GmbH, 01307 Dresden (DE)
(72) Erfinder: Blochwitz-Nimoth, Jan, 01097 Dresden (DE); Leo, Karl, 01219 Dresden (DE); Pfeiffer, Martin, 01069 Dresden (DE); Zhou, Xiang, Institut für Angewandte Photophysik, 01069 Dresden (DE)
(74) Vertreter: Bittner, Thomas L.
(86) Internationale Anmeldenummer: PCT/DE2003/001021
(87) Internationale Veröffentlichungsnummer: WO 2003/083958

(56) Entgegenhaltungen:
- EP-A- 0 498 979
- EP-A- 0 855 848
- EP-A- 1 017 118
- WO-A-01/67825
- WO-A-02/41414
- WO-A-98/10473
- DE-A- 10 135 513
- HUANG J ET AL: "LOW-VOLTAGE ORGANIC ELECTROLUMINESCENT DEVICES USING PIN STRUCTURES" APPLIED PHYSICS LETTERS, AMERICAN INSTITUTE OF PHYSICS. NEW YORK, US, Bd. 80, Nr. 1, 7. Januar 2002 (2002-01-07), Seiten 139-141, XP001092653 ISSN: 0003-6951
- ZHOU X ET AL: "LOW-VOLTAGE INVERTED TRANSPARENT VACUUM DEPOSITED ORGANIC LIGHT-EMITTING DIODES USING ELECTRICAL DOPING" APPLIED PHYSICS LETTERS, AMERICAN INSTITUTE OF PHYSICS. NEW YORK, US, Bd. 81, Nr. 5, 29. Juli 2002 (2002-07-29), Seiten 922-924, XP001133200 ISSN: 0003-6951

## Beschreibung

Die Erfindung betrifft ein transparentes und thermisch stabiles lichtemittierendes Bauelement mit organischen Schichten, insbesondere eine transparente organische Leuchtdiode nach den Oberbegriffen des Anspruchs 1.

Organische Leuchtdioden (OLED) sind seit der Demonstration niedriger Arbeitsspannungen von Tang et al. 1987 [C.W. Tang et al., Appl. Phys. Lett. 51 (12), 913 (1987)] aussichtsreiche Kandidaten für die Realisierung großflächiger Displays. Sie bestehen aus einer Folge dünner (typischerweise 1nm bis 1µm) Schichten aus organischen Materialien, welche bevorzugt im Vakuum aufgedampft oder aus der Lösung z.B. durch Schleudern aufgebracht werden. Diese Schichten sind deshalb typischerweise zu mehr als 80% transparent im sichtbaren Spektralbereich. Anderenfalls hätte die OLED durch Re-Absorption eine geringe externe Lichteffizienz. Die Kontaktierung der organischen Schichten mit einer Anode und einer Kathode erfolgt typischerweise mittels mindestens einer transparenten Elektrode (in den weitaus meisten Fällen mit einem transparenten Oxid, z.B. Indium-Zinn-Oxid ITO) und einem metallischen Kontakt. Typischerweise befindet sich dieser transparente Kontakt (z.B. das ITO) direkt auf dem Substrat. Im Falle wenigstens eines metallischen Kontaktes ist die OLED als Gesamtheit nicht transparent, sondern reflektiv oder streuend (durch entsprechende modifizierende Schichten, welche nicht zum eigentlichen OLED-Aufbau gehören). Im Falle des typischen Aufbaus mit der transparente Elektrode auf dem Substrat, emittiert die OLED durch das auf ihrer Unterseite befindliche Substrat.

Bei organischen Leuchtdioden wird durch die Injektion von Ladungsträgern (Elektronen von der einen, Löcher von der anderen Seite) aus den Kontakten in die dazwischen befindlichen organischen Schichten infolge einer äußeren angelegten Spannung, der folgenden Bildung von Exzitonen (Elektron-Loch-Paaren) in einer aktiven Zone und der strahlenden Rekombination dieser Exzitonen, Licht erzeugt und von der Leuchtdiode emittiert.

Der Vorteil solcher Bauelemente auf organischer Basis gegenüber den konventionellen Bauelementen auf anorganischer Basis (Halbleiter wie Silizium, Galliumarsenid) besteht darin, dass es möglich ist, sehr großflächige Anzeigeelemente (Bildschirme, Screens) herzustellen. Die organischen Ausgangsmaterialien sind gegenüber den anorganischen Materialien relativ preiswert (geringer Material- und Energieaufwand). Obendrein können diese Materialien aufgrund ihrer gegenüber anorganischen Materialien geringen Prozeßtemperatur auf flexible Substrate aufgebracht werden, was eine ganze Reihe von neuartigen Anwendungen in der Display- und Beleuchtungstechnik eröffnet.

Die übliche Anordnung solcher Bauelemente mit mindestens einer nicht-transparenten Elektrode stellt eine Folge aus einer oder mehrerer der folgenden Schichten dar:
1. Träger, Substrat,
2. Basiselektrode, löcherinjizierend (Pluspol), typischerweise transparent,
3. Löcher injizierende Schicht,
4. Löcher transportierende Schicht (HTL),
5. Licht emittierende Schicht (EL),
6. Elektronen transportierende Schicht (ETL),
7. Elektronen injizierende Schicht,
8. Deckelektrode, meist ein Metall mit niedriger Austrittsarbeit, elektroneninjizierend (Minuspol),
9. Kapselung, zum Ausschluß von Umwelteinflüssen.
Dies ist der allgemeinste Fall, meistens werden einige Schichten weggelassen (außer 2., 5. und 8.), oder aber eine Schicht kombiniert in sich mehrere Eigenschaften.
Der Lichtaustritt erfolgt bei der beschriebenen Schichtfolge durch die transparente Basiselektrode und das Substrat, während die Deckelektrode aus nicht transparenten Metallschichten besteht. Gängige Materialien für die transparente Basiselektrode sind Indium-Zinn-Oxid (ITO) und verwandte Oxidhalbleiter als Injektionskontakt für Löcher (ein transparenter entarteter Halbleiter). Für die Elektroneninjektion kommen unedle Metalle wie Aluminium (Al), Magnesium (Mg), Kalzium (Ca) oder eine Mischschicht aus Mg und Silber (Ag) oder solche Metalle in Kombination mit einer dünnen Schicht eines Salzes wie Lithiumfluorid (LiF) zum Einsatz.

Üblicherweise sind diese OLEDs nicht transparent. Es gibt aber auch Anwendungen, für die die Transparenz von entscheidender Bedeutung ist. So ließe sich ein Anzeigeelement herstellen, welches im ausgeschalteten Zustand transparent erscheint, die dahinter liegende Umgebung also wahrgenommen werden kann, im eingeschalteten Zustand dem Betrachter jedoch eine Information zukommen läßt. Denkbar sind hier Anwendungen für Displays in Autoscheiben oder Displays für Personen, welche durch das Display nicht in ihrer Bewegungsfreiheit eingeschränkt werden dürfen (z.B. Head-On Displays für Überwachungspersonal). Solche transparenten OLEDs, welche die Grundlage für transparente Displays darstellen, sind z.B. bekannt aus:
1: G. Gu, V. Bulovic, P.E. Burrows, S.R. Forrest , Appl. Phys. Lett., **68**, 2606 (1996),
2: G. Gu, V. Khalfin, S.R. Forrest, Appl. Phys. Lett., **73**, 2399 (1998),
3: G. Parthasarathy et al., Appl. Phys. Lett. **72**, 2138 (1997),
4: G. Parthasarathy et al., Adv. Mater. **11**, 907 (1997),
5: G. Gu, G. Parthasarathy, S.R. Forrest, Appl. Phys. Lett., **74**, 305 (1999).
In (1) wird die Transparenz dadurch erreicht, dass als Grundelektrode (das heißt, direkt auf dem Substrat) die herkömmliche transparente Anode ITO verwendet wird. Hierbei ist festzustellen, daß es günstig für die Betriebsspannung der OLED ist, wenn die ITO-Anode in spezieller Art und Weise (z.B. Ozon-Sputtern, Plasma-Veraschen) vorbehandelt wird, mit dem Ziel die Austrittsarbeit der Anode zu erhöhen (z.B. C.C. Wu et al., Appl. Phys Lett. 70, 1348 (1997); G. Gu et al., Appl. Phys. Lett. 73, 2399 (1998)). Die Austrittsarbeit von ITO kann z.B. durch Ozonierung und/oder Sauerstoff-Plasma Veraschung von ca. 4.2eV bis zu ca. 4.9eV verändert werden. Dann können Löcher effizienter aus der ITO-Anode in die Löchertransportschicht injiziert werden. Diese Vorbehandlung der ITO-Anode ist aber nur möglich, falls sich die Anode direkt auf dem Substrat befindet. Dieser Aufbau der OLED wird als nicht-invertiert bezeichnet, der Aufbau der OLED mit der Kathode auf dem Substrat als invertierter Aufbau. Als Deckelektrode kommt in (1) eine Kombination aus einer dünnen, semitransparenten Schicht, eines unedlen Metalls (Magnesium, stabilisiert durch Beimischung von Silber) und einer leitfähigen transparenten Schicht aus dem bekannten ITO zum Einsatz. Diese Kombination ist deshalb notwendig, weil die Austrittsarbeit des ITO zu hoch ist, als dass effizient Elektronen direkt in die Elektronentransportschicht injiziert werden können, und damit OLEDs mit niedrigen Betriebsspannungen herstellbar wären. Dies wird mittels der sehr dünnen Magnesium Zwischenschicht umgangen. Das entstehende Bauelement ist wegen der dünnen metallischen Zwischenschicht semitransparent (Transparenz der Deckelektrode ca. 50-80%), während die Transparenz der als voll-transparent geltenden ITO Anode bei über 90% liegt. In (1) wird auf die metallische Zwischenschicht noch ein ITO-Kontakt durch einen Sputter-Prozess aufgebracht, um die seitliche Leitfähigkeit zu den Anschlusskontakten der OLED-Umgebung zu gewährleisten. Der ITO Sputter-Prozess hat die Folge, dass die metallische Zwischenschicht nicht dünner als 7.5nm (1) ausgelegt werden darf, sonst sind die Sputter-Schäden an den darunterliegenden organischen Schichten zu hoch. Strukturen dieser Art sind auch in den folgenden Patenten beschrieben: US Patent Nr. 5,703,436 (S.R. Forrest et al.), eingereicht am 6.3.1996; US Patent Nr. 5,757,026 (S.R. Forrest et al.), eingereicht am 15.4.1996; US Patent Nr. 5,969,474 (M. Arai), eingereicht am 24.10.1997. Zwei OLEDs übereinander mit den in (1) beschriebenen Kathoden sind im Zitat (2) beschrieben: hier werden eine grüne und eine rote OLED übereinander hergestellt (,stacked OLED' - gestapelte OLED). Da beide OLEDs semitransparent sind kann durch entsprechende Spannungen an den dann 3 Elektroden, die Emissionsfarbe gezielt gewählt werden.

Eine andere bekannte Realisierung von transparenten OLEDs sieht eine organische Zwischenschicht zur Verbesserung der Elektronen-Injektion vor (Zitate 3-5). Dabei befindet sich zwischen der licht emittierenden Schicht (z.B. Aluminim-tris-quinolate, Alq3) und der als Kathode benutzten transparenten Elektrode (z.B. ITO) eine organische Zwischenschicht. In den meisten Fällen handelt es sich dabei um Kupfer-Phthalocyanin (CuPc). Diese Material ist eigentlich ein Löchertransportmaterial (höhere Löcher- als Elektronenbeweglichkeit). Es hat allerdings den Vorzug einer hohe thermischen Stabilität. Die aufgesputterte Deckelektrode kann also nicht so viel Schaden an den darunterliegenden organischen schichten anrichten. Ein Vorteil und gleichzeitig ein Nachteil dieser CuPc Zwischenschicht ist die geringe Bandlücke (Abstand HOMO - höchstes besetztes Molekülorbital - zum LUMO - niedrigsten unbesetztes Molekülorbital). Der Vorteil besteht darin, dass wegen der niedrigen LUMO Position relativ leicht Elektronen aus ITO injiziert werden können, aber die Absorption wegen der geringen Bandlücke im sichtbaren Bereich hoch ist. Die Schichtdicke von CuPc muss deshalb auf unter 10nm beschränkt werden. Desweiteren ist die Injektion von Elektronen aus CuPc in Alq3 oder einem anderen Emissionsmaterial schwierig, da deren LUMO's generell höher liegen. Eine weitere Realisierung der transparenten Kathode oben auf der OLED wurde von Pioneer vorgeschlagen (US Patent Nr. 5,457,565 (T. Namiki), eingereicht am 18.11.1993). Dabei wird anstelle der CuPc Schicht eine dünne Schicht aus einem alkalischen Erd-Metall-Oxid (z.B. LiO2) verwendet. Dieses verbessert die ansonsten schlechte Elektroneninjektion aus der transparenten Kathode in die lichtemittierende Schicht.

Eine weitere Realisierung der transparenten OLED (G. Parthasarathy et al., Appl. Phys. Lett., **76**, 2128 (2000), WO Patent 01/67825 A1 (G. Parthasarathy), eingereicht am 7.3.2001, Prioritätsdatum 9.3.2000) sieht eine zusätzliche Elektronentransportschicht (z.B. BCP - Bathocuproine mit hoher Elektronenbeweglichkeit) in Kontakt mit der transparenten Kathode (z.B. ITO) vor. Entweder zwischen der lichtemittierenden Schicht und der (dünnen < 10nm) Elektronentransportschicht oder zwischen der Elektronentransportschicht und der ITO Kathode befindet sich eine ca. 1nm dicke reine Schicht aus dem alkalischen Metall Lithium (Li). Diese Li Zwischenschicht erhöht die Elektroneninjektion aus der transparenten Elektrode drastisch. Die Erklärung dieses Effektes ist eine Diffusion der Li-Atome in die organische Schicht und anschliessende ,Dotierung' mit Bildung einer hochleitfähigen Zwischenschicht (entarteter Halbleiter). Auf diese wird dann eine transparente Kontaktschicht (meistens ITO) aufgebracht.

Aus den obigen Arbeiten werden folgende Punkte klar:
1. Die Auswahl an transparenten Elektroden ist beschränkt (im Wesentlichen ITO oder ähnliche entartete anorganische Halbleiter).
2. Die Austrittsarbeiten der transparenten Elektroden favorisieren prinzipiell Löcherinjektion, aber auch dafür ist eine spezielle Behandlung der Anode notwendig, um ihre Austrittsarbeit weiter abzusenken.
3. Alle bisherigen Entwicklungen laufen daraus hinauf eine passende Zwischenschicht zu finden, welche die Injektion von Elektronen in die organischen Schichten verbessert.

Für Leuchtdioden aus anorganischen Halbleitern ist bekannt, dass durch hochdotierte Randschichten dünne Raumladungszonen erreicht werden können, die auch bei vorhandenen energetischen Barrieren durch Tunneln zu effizienter Injektion von Ladungsträgern führen. Unter Dotierung ist hierbei (wie für anorganische Halbleiter üblich) die gezielte Beeinflussung der Leitfähigkeit der Halbleiterschicht durch die Beimischung von Fremdatomen/Molekülen zu verstehen. Für organische Halbleiter wird als Dotierung oft die Beimischung von speziellen Emittermolekülen zur organischen Schicht gemeint; davon ist zu unterscheiden. Die Dotierung organischer Materialien wurde im US Patent Nr. 5,093,698, eingereicht am 12.2.1991, beschrieben. Dies führt aber bei praktischen Anwendungen zu Problemen mit der Energieangleichung der verschiedenen Schichten und Verminderung der Effizienz der LEDs mit dotierten Schichten.

Die Aufgabe der hier vorgestellten Erfindung besteht darin, eine voll transparente (>70% Transmission) organische Leuchtdiode anzugeben, die mit einer verringerten Betriebsspannung betrieben werden kann und eine hohe Lichtemissionseffizienz aufweist. Gleichzeitig soll der Schutz aller organischer Schichten, insbesondere aber der Licht emittierenden Schichten, vor Schäden infolge der Herstellung des transparenten Deckkontaktes gewährleistet sein. Das entstehende Bauelement soll stabil sein (Operations-Temperaturbereich bis 80°C, Langzeitstabilität).

Erfindungsgemäß wird die Aufgabe in Verbindung mit den im Oberbegriff des Anspruchs 1 genannten Merkmalen dadurch gelöst, dass die Löchertransportschicht mit einem akzeptorartigen organischen Material p-dotiert ist und die Elektronentransportschicht mit einem donatorartigen organischen Material n-dotiert ist, und die molekularen Massen der Dotanden größer als 200g/mol sind.

Wie in DE 101 35 513 (Leo et al., eingereicht am 20.7.2001) beschrieben, kann man den Schichtreihenfolge der OLED umdrehen, also den löcherinjizierenden (transparenten) Kontakt (Anode) als Deckelektrode realisieren. Gewöhnlich führt dies dazu, dass bei invertierten organischen Leuchtdioden die Betriebsspannungen wesentlich höher sind als bei vergleichbaren nicht-invertierten Strukturen. Die Ursache dafür liegt in der schlechteren Injektion aus den Kontakten in die organischen Schichten, weil die Austrittsarbeit der Kontakte nicht mehr gezielt optimiert werden kann.

Bei der erfindungsgemäßen Lösung hängt die Injektion von Ladungsträgern aus den Elektroden in die organischen Schichten (egal ob Löcher- oder Elektronentransportschichten) nicht mehr so stark von der Austrittsarbeit der Elektroden selbst ab. Damit ist es also möglich, auf beiden Seiten des OLED-Bauelementes den gleichen Elektroden-Typ, also z.B. zwei gleiche transparente Elektroden, z.B. ITO, zu verwenden.

Die Ursache für die Erhöhung der Leitfähigkeit ist eine erhöhte Dichte von Gleichgewichtsladungsträgern in der Schicht. Die Transportschicht kann dabei höhere Schichtdicken aufweisen als es bei undotierten Schichten möglich ist (typischerweise 20-40nm), ohne die Betriebsspannung drastisch zu erhöhen. Analog ist die elektroneninjizierende Schicht zunächst der Kathode mit einem donatorartigen Molekül (bevorzugt organisches Molekül oder Bruchstücke davon, siehe DE 102 07 859) n-dotiert, was zu einer Erhöhung der Elektronen-Leitfähigkeit aufgrund höherer intrinsischen Ladungsträgerdichte führt. Auch diese Schicht kann im Bauelement dicker ausgeführt werde, als dies mit undotierten Schichten möglich wäre, da dies zu einer Erhöhung der Betriebsspannung führen würde. Beide Schichten sind also dick genug um die darunter befindlichen Schichten vor Schäden während des Herstellungsprozesses (Sputtern) der transparenten Elektrode (z.B. ITO) zu schützen.

In den dotierten Ladungsträgertransportschichten (Löcher oder Elektronen) an den Elektroden (Anode oder Kathode) wird eine dünne Raumladungszone erzeugt, durch welche die Ladungsträger effizient injiziert werden können. Aufgrund der Tunnelinjektion wird durch die sehr dünne Raumladungszone die Injektion auch bei einer energetisch hohen Barriere nicht mehr behindert. Vorteilhaft ist die Ladungsträgertransportschicht durch eine Beimischung einer organischen oder anorganischen Substanz (Dotand) dotiert. Diese großen Moleküle bauen sich stabil in das Matrixmolekülgerüst der Ladungsträgertransportschichten ein. Dadurch wird eine hohe Stabilität beim Betrieb der OLED (keine Diffusion) sowie unter thermischer Belastung erreicht.

In DE 100 58 578, eingereicht am 25.11.2000, (siehe auch X. Zhou et al., Appl. Phys. Lett. **78**, 410 (2001)) wird beschrieben, dass organische Leuchtdioden mit dotierten Transportschichten nur effiziente Lichtemission zeigen, wenn die dotierten Transportschichten auf geeignete Weise mit Blockschichten kombiniert werden. In einer vorteilhaften Ausführungsform werden deshalb die transparenten Leuchtdioden ebenfalls mit Blockschichten versehen. Die Blockschicht befindet sich jeweils zwischen der Ladungsträgertransportschicht und einer lichtemittierenden Schicht des Bauelementes, in welcher die Umwandlung der elektrischen Energie der durch Stromfluß durch das Bauelement injizierten Ladungsträger in Licht stattfindet. Die Substanzen der Blockschichten werden erfindungsgemäß so gewählt, daß sie bei angelegter Spannung (in Richtung der Betriebsspannung) aufgrund ihrer Energieniveaus die Majoritätsladungsträger (HTL-Seite: Löcher, ETL-Seite: Elektronen) an der Grenzschicht dotierte Ladungsträgertransportschicht/Blockschicht nicht zu stark behindert wird (niedrige Barriere), aber die Minoritätsladungsträger effizient an der Grenzschicht Licht emittierende Schicht/Blockschicht aufgehalten werden (hohe Barriere). Desweiteren soll die Barrierenhöhe zur Injektion von Ladungsträgern aus der Blockschicht in die emittierende Schicht so klein sein, dass die Umwandlung eines Ladungsträgerpaares an der Grenzfläche in ein Exciton in der emittierenden Schicht energetisch vorteilhaft ist. Dies verhindert Exziplexbildung an den Grenzflächen der lichtemittierten Schicht, welche die Effizienz der Lichtemission verringert. Da die Ladungsträgertransportschichten bevorzugt eine hohe Bandlücke aufweisen, können die Blockschichten sehr dünn gewählt werden, da trotzdem kein Tunneln von Ladungsträgern aus der lichtemittierenden Schicht in Energiezustände der Ladungsträgertransportschichten möglich ist. Dies erlaubt es, trotz Blockschichten eine niedrige Betriebsspannung zu erreichen.

Eine vorteilhafte Ausführung einer Struktur einer erfindungsgemäßen transparenten OLED beinhaltet folgende Schichten (nicht-invertierter Aufbau):
1. Träger, Substrat,
2. transparente Elektrode, z.B. ITO, Löcher injizierend (Anode=Pluspol),
3. p-dotierte, Löcher injizierende und transportierende Schicht,
4. dünne löcherseitige Blockschicht aus einem Material dessen Bandlagen zu den Bandlagen der sie umgebenden Schichten passt,
5. lichtemittierende Schicht (evtl. mit Emitterfarbstoff dotiert),
6. dünne elektronenseitige Blockschicht aus einem Material, dessen Bandlagen zu den Bandlagen der sie umgebenden Schichten passt,
7. n-dotierte Elektronen injizierende und transportierende Schicht,
8. transparente Elektrode, elektronenjizierend (Kathode=Minuspol),
9. Kapselung, zum Ausschluß von Umwelteinflüssen.

Eine zweite vorteilhafte Ausführung einer Struktur einer erfindungsgemäßen transparenten OLED beinhaltet folgende Schichten (invertierter Aufbau):
1. Träger, Substrat,
2a. transparente Elektrode, z.B. ITO, Elektronen injizierend (Kathode=Minuspol),
3a. n-dotierte, Elektronen injizierende und transportierende Schicht,
4a. dünne elektronenseitige Blockschicht aus einem Material dessen Bandlagen zu den Bandlagen der sie umgebenden Schichten passt,
5a. lichtemittierende Schicht (evtl. mit Emitterfarbstoff dotiert),
6a. dünne löcherseitige Blockschicht aus einem Material, dessen Bandlagen zu den Bandlagen der sie umgebenden Schichten passt,
7a. p-dotierte Löcher injizierende und transportierende Schicht,
8a. transparente Elektrode, Löcher injizierend (Anode=Pluspol), z.B. ITO,
9. Kapselung, zum Ausschluß von Umwelteinflüssen.

Es ist auch im Sinne der Erfindung, wenn nur eine Blockschicht Verwendung findet, weil die Bandlagen der injizierenden und transportierenden Schicht und der Lichtemissionsschicht bereits auf einer Seite zueinander passen. Des weiteren können die Funktionen der Ladungsträgerinjektion und des Ladungsträgertransports in den Schichten 3 und 7 auf mehrere Schichten aufgeteilt sein, von denen mindestens eine (und zwar die zunächst der Elektroden) dotiert ist. Wenn die dotierte Schicht sich nicht unmittelbar an der jeweiligen Elektrode befindet, so müssen alle Schichten zwischen der dotierten Schicht und der jeweiligen Elektrode so dünn sein, dass sie effizient von Ladungsträgern durchtunnelt werden können (<10nm). Diese Schichten können dicker sein, wenn sie eine sehr hohe Leitfähigkeit aufweisen (der Bahnwiderstand dieser Schichten muss geringer sein als der der benachbarten dotierten Schicht). Dann sind die Zwischenschichten im Sinne der Erfindung als ein Teil der Elektrode zu betrachten. Die molaren Dotierungskonzentrationen liegen typischerweise im Bereich von 1:10 bis 1:10000. Die Dotanden sind organische Moleküle mit Molekülmassen oberhalb 200g/mol.

Die Erfindung wird nachfolgend an Hand von Ausführungsbeispielen noch näher erläutert. In den Zeichnungen ist folgendes dargestellt:

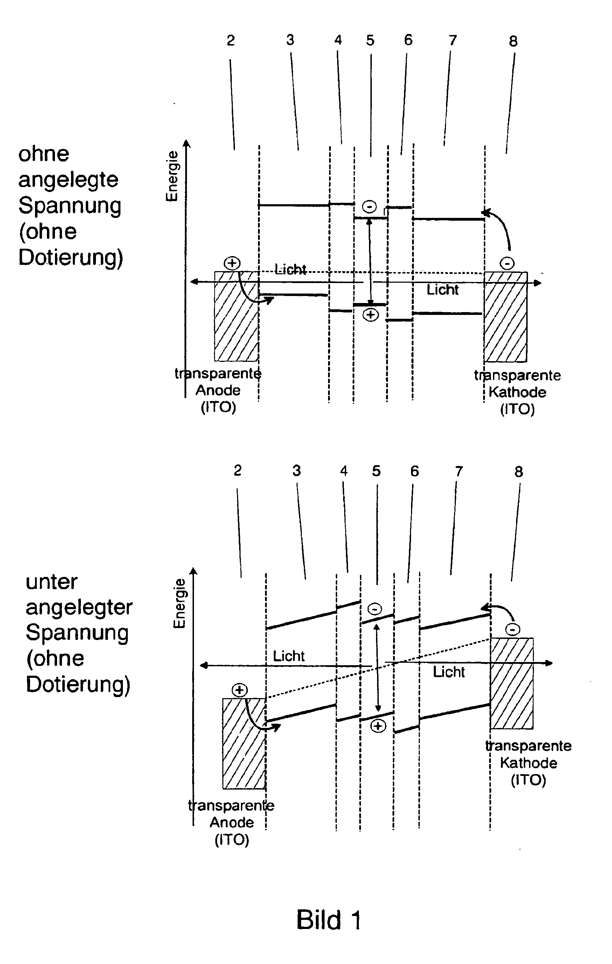

- Bild 1: Ein Energiediagramm einer transparenten OLED in der bisher üblichen Ausführungsform (ohne Dotierung, die Zahlenangaben beziehen sich auf die oben beschriebene nicht-invertierte Schichtstruktur der OLED). Oben ist die Lage der Energieniveaus (HOMO und LUMO) ohne externe Spannung beschrieben (man sieht, dass die beiden Elektroden gleiche Austrittsarbeit besitzen), unten mit angelegter externer Spannung. Der Einfachheit halber sind hier auch die Blockschichten **4** und **6** mit eingezeichnet.

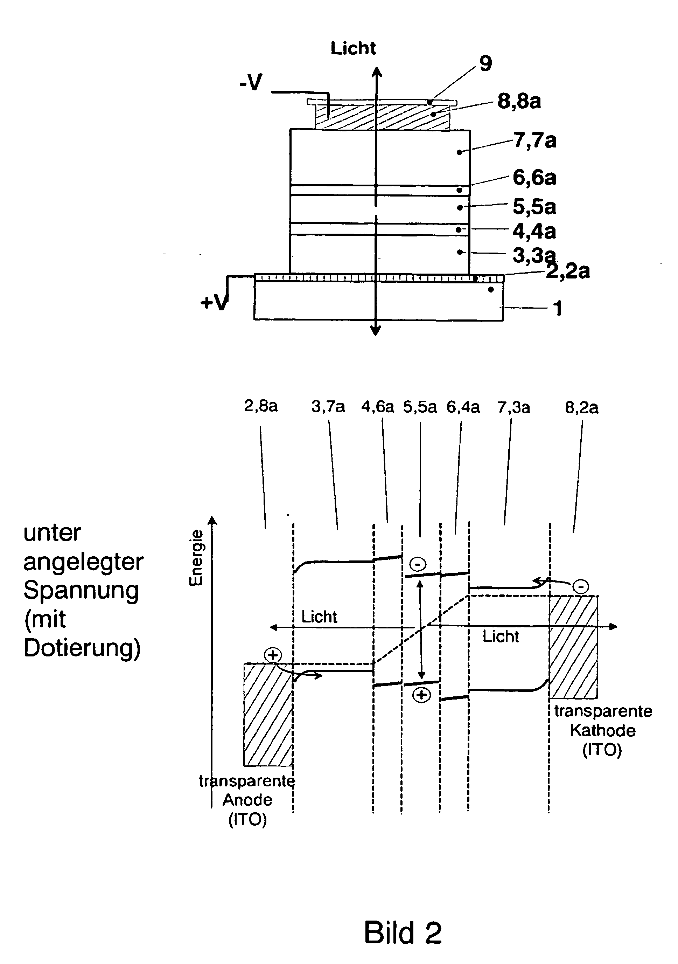

- Bild 2: Ein Energiediagramm einer transparenten OLED mit dotierten Ladungsträgertransportschichten und passenden Blockschichten (man beachte die Bandverbiegung zunächst den Kontaktschichten, hier in beiden Fällen ITO). Die Zahlenangaben beziehen sich auf beide oben beschriebene Ausführungen. Oben ist der Aufbau des Bauelementes gezeigt, welches aufgrund seiner Transparenz in beide Richtungen Licht emittiert, unten die Bandstruktur.

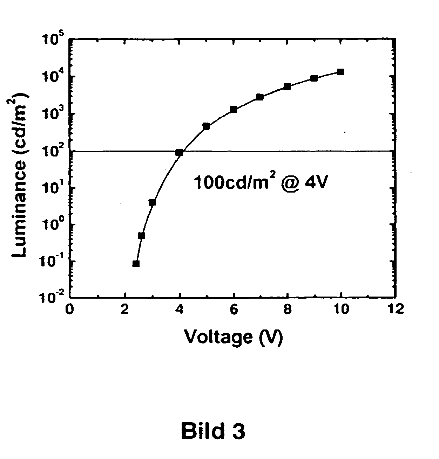

- Bild 3: Leuchtdichte-Spannungs-Kennlinie des unten aufgeführten Ausführungsbeispieles, die typische Monitor-Leuchtdichte von 100cd/m² wird bereits bei 4V erreicht. Die Effizienz beträgt 2cd/A. Allerdings kommt hier als Anodenmaterial aus technologischen Gründen kein transparenter Kontakt (z.B. ITO) zur Verwendung, sondern dieser wird mittels eines semi-transparenten (50%) Goldkontaktes simuliert. Es handelt sich also um eine semi-transparente OLED.

In der in Bild 1 gezeigten Ausführungsform tritt keine Raumladungszone an den Kontakten auf. Diese Ausführung verlangt nach einer niedrigen energetischen Barriere für die Ladungsträgerinjektion. Dies kann unter Umständen mit verfügbaren Materialien nicht oder nur schwer erreicht werden (siehe Stand der Technik, oben). Die Injektion von Ladungsträgern aus den Kontakten ist daher nicht so effektiv. Die OLED weist eine erhöhte Betriebsspannung auf.

Erfindungsgemäß wird der Nachteil der bisherigen Strukturen durch transparente OLEDs mit dotierten Injektions- und Transportschichten, ggf. in Verbindung mit Blockschichten, vermieden. Bild 2 zeigt eine entsprechende Anordnung. Hierbei sind die ladungsträgerinjizierenden und -leitenden Schichten **3** und **7** dotiert, so dass sich an den Grenzschichten zu den Kontakten **2** und **8** Raumladungszonen ausbilden. Bedingung ist, dass die Dotierung hoch genug ist, dass diese Raumladungszonen leicht durchtunnelt werden können. Dass solche Dotierungen möglich sind, wurde zumindest für die p-Dotierung der Löchertransportschicht in der Literatur für nicht transparente Leuchtdioden bereits gezeigt (X.Q. Zhou et al., Appl. Phys. Lett. 78, 410 (2001); J. Blochwitz et al., Organic Elecronics 2, 97 (2001) J. Huang et al., Appl. Phys. Lett. 80, 139 (2002); EP 1017118).

Diese Anordnung zeichnet sich durch folgende Vorzüge aus:
- Eine hervorragende Injektion der Ladungsträger von den Elektroden in die dotierten Ladungsträgertransportschichten.
- Die Unabhängigkeit von der detaillierten Präparation des Ladungsträgerinjizierenden Materialen **2** und **8**.
- Die Möglichkeit, für die Elektroden **2** und **8** auch Materialien mit vergleichsweise hohen Barrieren für die Ladungsträgerinjektion zu wählen, z.B. in beiden Fällen das gleiche Material, z.B. ITO.

Im folgenden wird ein bevorzugtes Ausführungsbeispiel angegeben. Allerdings kommt bei diesem noch keine n-Dotierung der Elektronentransportschicht mit stabilen großen organischen Dotanden vor. Als Beispiel für die Wirksamkeit des Konzeptes der transparenten OLED mit dotierten organischen Transportschichten wird eine Ausführung mit der nicht stabilen n-Dotierung eines typischen Elektronentransportmaterials (Bphen bathophenathroline) mit Li gezeigt (Patent US 6,013,384 (J. Kido et al.), eingereicht am 22.1.1998; J. Kido et al., Appl. Phys. Lett. 73, 2866 (1998)). Wie schon im Stand der Technik beschrieben kann diese ca. 1:1 Mischung aus Li und Bphen die Wirksamkeit der Dotierung demonstrieren. Allerdings ist diese Schicht thermisch und betreibungsmäßig nicht stabil. Da bei dieser Dotierung sehr hohe Dotandenkonzentrationen vorkommen, muß auch davon ausgegangen werden, dass der Mechanismus der Dotierung ein anderer ist. Bei der Dotierung mit organischen Molekülen und Dotierungsverhältnissen zwischen 1:10 und 1:10000 ist davon auszugehen, dass der Dotand die Struktur der Ladungsträgertransportschicht nicht wesentlich beeinflußt. Davon kann bei der 1:1 Beimischung von Dotierungsmetallen, z.B. Li, nicht ausgegangen werden.

Die OLED weist folgende Schichtstruktur auf (invertierter Aufbau):
- **1a**: Substrat, z.B. Glas,
- **2a**: Kathode: ITO wie gekauft, nicht behandelt,
- **3a**: n-dotierte Elektronentransportierende Schicht: 20nm Bphen:Li 1:1 molekulares Mischungsverhältnis,
- **4a**: elektronenseitige Blockschicht: 10nm Bphen,
- **5a:** elektrolumineszierende Schicht: 20nm Alq₃, kann mit Emitterdotanden gemischt werden, zur Erhöhung der internen Quantenausbeute der Lichterzeugung,
- **6a**: löcherseitige Blockschicht: 5nm Triphenyldiamin (TPD),
- **7a**: p-dotierte Löchertransportierende Schicht: 100nm Starburst m-MTDATA 50:1 dotiert mit F₄-TCNQ Dotand (thermisch stabil bis etwa 80°C),
- **8a**: transparente Elektrode (Anode): Indium-Zinn-Oxid (ITO).

Die gemischten Schichten **3** und **7** werden in einem Aufdampfprozeß im Vakuum in Mischverdampfung hergestellt. Prinzipiell können solche Schichten auch durch andere Verfahren hergestellt werden, wie z.B. einem Aufeinanderdampfen der Substanzen mit anschließender möglicherweise temperaturgesteuerter Diffusion der Substanzen ineinander; oder durch anderes Aufbringen (z.B. Aufschleudern) der bereits gemischten Substanzen im oder außerhalb des Vakuums. Die Blockschichten **3** und **6** wurden ebenfalls im Vakuum aufgedampft, können aber auch anders hergestellt werden, z.B. durch Aufschleudern innerhalb oder außerhalb des Vakuums.

In Bild 3 ist die Leuchtdichte-Spannungs-Kennlinie einer semi-transparenten OLED dargestellt. Zu Testzwecken wurde ein semi-transparenter Goldkontakt als Anode verwendet (50% Transmission). Es wird eine Betriebsspannung von 4V für eine Leuchtdichte von 100cd/m2 benötigt. Dies ist eine der kleinsten realisierten Betriebsspannungen für transparente OLEDs, besonders mit invertiertem Schichtaufbau. Diese OLED demonstriert die Realisierbarkeit des hier vorgestellten Konzeptes. Aufgrund der semi-transparenten Deckelektrode erreicht die externe Stromeffizienz nur einen Wert von ca. 2cd/A und nicht 5cd/A, wie er maximal für OLEDs mit reinem Alq3 als Emitterschicht zu erwarten ist.

Die erfindungskonforme Anwendung dotierter Schichten erlaubt es, nahezu die gleichen niedrigen Betriebsspannungen und hohen Effizienzen in einer transparenten Struktur zu erreichen wie sie bei einer herkömmlichen Struktur mit einseitiger Emission durch das Substrate auftreten. Dies liegt, wie beschrieben, an der effizienten Ladungsträgerinjektion, welche dank der Dotierung relativ unabhängig von der exakten Austrittsarbeit der transparenten Kontaktmaterialien sind. Somit lassen sich die gleichen Elektrodenmaterialien (oder sich in ihrer Austrittsarbeit nur wenig unterscheidenden transparenten Elektrodenmaterialien) als Elektronen- und Löcherinjizierender Kontakt verwenden.

Aus den Ausführungsbeispielen ist es für den Fachmann offensichtlich, dass viele Modifikationen und Variationen der vorgestellten Erfindung möglich sind, welche im Sinne der Erfindung sind. Zum Beispiel können andere transparente Kontakte als ITO als Anodenmaterialien verwendet werden (z.B. wie in H. Kim et al., Appl. Phys. Lett. 76, 259 (2000); H. Kim et al., Appl. Phys. Lett. 78, 1050 (2001)). Weiterhin ist es erfindungskonform die transparenten Elektroden mit einer hinreichend dünnen Zwischenschicht eines nicht transparenten Metalls (z.B. Silber oder Gold) und einer dicken Schicht des transparenten leitfähigen Materials zusammenzusetzen. Die Dicke der Zwischenschicht muss und kann (da wegen der dicken dotierten Ladungsträgertransportschichten keine Schäden beim Sputtern an den Lichtemittierenden Schichten zu erwarten sind) dann so dünn sein, dass das gesamte Bauelement noch transparent im obigen Sinne ist (Transparenz im gesamten sichtbaren Spektralbereich > 75%). Eine weitere erfindungskonforme Ausführung besteht darin, dass für die dotierte Elektronentransportschicht ein Material zum Einsatz kommen, dessen LUMO-Niveau zu tief liegt (im Sinne von Bild 1 und 2: Schicht 7 bzw. 3a) als das noch effizient Elektronen in die Block- und die Licht emittierende Schicht (6 bzw 4a und 5 bzw. 5a) injiziert werden können (also größere Barriere als in Bild 2 dargestellt). Dann kann zwischen der n-artig dotierten Elektronentransportschicht (7 bzw. 3a) und der Blockschicht (6 bzw. 4a) bzw. der Licht emittierenden Schicht (5 bzw. 5a) eine sehr dünne (<2.5nm) Metallschicht eines Metalls mit niedrigerer Austrittsarbeit als die Lage des LUMO's der dotierten Transportschicht zum Einsatz kommen. Die Metallschicht muss so dünn sein, dass die gesamte Transparenz des Bauelementes nicht wesentlich vermindert wird (siehe L.S. Hung, M.G. Mason, Appl. Phys. Lett. **78** (2001) 3732).

### Bezugszeichenliste

- 1: Substrat
- 2,2a: Anode bzw. Kathode
- 3,3a: Löcher- bzw. Elektronentransportschicht (dotiert)
- 4,4a: löcher- bzw. elektronenseitige dünne Blockschicht
- 5,5a: lichtemittierende Schicht
- 6,6a: elektronen- bzw. löcherseitige Blockschicht
- 7,7a: Elektronen- bzw. Löchertransportschicht (dotiert)
- 8,8a: Kathode bzw. Anode
- 9: Kapselung

## Patentansprüche

1. Transparentes, thermisch stabiles lichtemittierendes Bauelement mit organischen Schichten, insbesondere organische Leuchtdiode, umfassend eine Anordnung von Schichten mit einem transparenten Substrat (1) und zwei Elektroden, mit denen eine Anode (2; 8a) und eine Kathode (8; 2a) gebildet sind, wobei die Anode (2; 8a) transparent ist, zwischen den beiden Elektroden eine Löchertransportschicht (3; 7a), wenigstens eine Licht emittierende Schicht (5; 5a) und eine Elektronentransportschicht (7; 3a) angeordnet sind und die Löchertransportschicht (3; 7a) mit einem akzeptorartigen organischen Material p-dotiert ist, **dadurch gekennzeichnet, dass** die Kathode (8; 2a) transparent ist und die Elektronentransportschicht (7; 3a) mit einem donatorartigen organischen Material n-dotiert ist, wobei eine molekulare Masse des akzeptorartigen organischen Materials und eine molekulare Masse des donatorartigen organischen Materials größer als 200g/mol sind.

2. Lichtemittierendes Bauelement nach Anspruch 1, **dadurch gekennzeichnet, dass** zwischen der dotierten Löchertransportschicht (3; 7a) und der Licht emittierenden Schicht (5; 5a) eine löcherseitige Blockschicht (4; 6a) vorgesehen ist.

3. Lichtemittierendes Bauelement nach Anspruch 1 oder 2, **dadurch gekennzeichnet, dass** zwischen der dotierten Elektronentransportschicht (7; 3a) und der Licht emittierenden Schicht (5; 5a) eine elektronenseitige Blockschicht (6; 4a) vorgesehen ist.

4. Lichtemittierendes Bauelement nach einem der Ansprüche 1 bis 3, **dadurch gekennzeichnet, dass** die zwei transparenten Elektroden vom gleichen Elektroden-Typ sind.

5. Lichtemittierendes Bauelement nach einem der Ansprüche 1 bis 4, **dadurch gekennzeichnet, dass** die zwei transparenten Elektroden aus Indium-Zinn-Oxid (ITO) bestehen.

6. Lichtemittierendes Bauelement nach einem der Ansprüche 1 bis 5, **dadurch gekennzeichnet, dass** die zwei transparenten Elektroden aus einem zu ITO ähnlichen transparenten Material bestehen, nämlich einem anderen entarteten Oxidhalbleiter.

7. Lichtemittierendes Bauelement nach einem der Ansprüche 1 bis 6, **dadurch gekennzeichnet, dass** die zwei transparenten Elektroden aus unterschiedlichen transparenten Kontaktmaterialien bestehen.

8. Lichtemittierendes Bauelement nach einem der Ansprüche 1 bis 7, **dadurch gekennzeichnet, dass** zwischen der Elektronentransportschicht (7; 3a) und der transparenten Kathode (8; 2a) und/oder zwischen der transparenten Anode (2; 8a) und der Löchertransportschicht (3; 7a) jeweils eine dünne (<10nm) kontaktverbessernde Schicht vorgesehen ist, welche leicht durchtunnelt werden kann.

9. Lichtemittierendes Bauelement nach einem der Ansprüche 1 bis 8, **dadurch gekennzeichnet, dass** die lichtemittierende Schicht (5; 5a) eine Mischschicht aus mehreren Materialien ist.

10. Lichtemittierendes Bauelement nach einem der Ansprüche 1 bis 9, **dadurch gekennzeichnet, dass** die Löchertransportschicht (3 ; 7a) aus einer organischen Hauptsubstanz und dem akzeptorartigen organischen Material besteht.

11. Lichtemittierendes Bauelement nach einem der Ansprüche 1 bis 10, **dadurch gekennzeichnet, dass** die Elektronentransportschicht (7; 3a) aus einer Mischung einer organischen Hauptsubstanz und dem donatorartigen organischen Material besteht.

12. Lichtemittierendes Bauelement nach einem der Ansprüche 1 bis 11, **dadurch gekennzeichnet, dass** eine oben angeordnete der zwei transparenten Elektroden (8; 8a) mit einer transparenten Schutzschicht (9) versehen ist.

13. Lichtemittierendes Bauelement nach einem der Ansprüche 1 bis 12, **dadurch gekennzeichnet, dass** die oben angeordnete, transparente Elektrode (8; 8a) mit einer sehr dünnen (<5nm) metallischen Zwischenschicht zur darunterliegenden Elecktronen/Löchertransportschicht (7; 7a) versehen ist, so daß die Transparenz im gesamten sichtbaren Spektralbereich größer als 75% ist.

14. Lichtemittierendes Bauelement nach einem der Ansprüche 1 bis 13, **dadurch gekennzeichnet, dass** eine unten angeordnete der zwei transparenten Elektroden (2; 2a) mit einer sehr dünnen (<5nm) metallischen Zwischenschicht zur darüberliegenden Löcher/Elektronenschicht (3; 3a) versehen ist, so daß die Transparenz im gesamten sichtbaren Spektralbereich größer als 75% ist.

15. Lichtemittierendes Bauelement nach einem der Ansprüche 1 bis 14, **dadurch gekennzeichnet, dass** eine Anordnung aus mit der p-dotierten Löchertransportschicht (3; 7a) und der transparenten Anode (2; 8a) mehrfach gebildet ist.

16. Lichtemittierendes Bauelement nach einem der Ansprüche 1 bis 15, **dadurch gekennzeichnet, dass** eine Anordnung der n-dotierten Elektronentransportschicht (7; 3a) und der transparenten Kathode (8; 2a) mehrfach gebildet ist.

17. Lichtemittierendes Bauelement nach einem der Ansprüche 1 bis 16, **dadurch gekennzeichnet, dass** zwischen der Elektronentransportschicht (7; 3a) und der elektronenseitigen Blockschicht (6; 4a) / der Licht emittierenden Schicht (5; 5a) eine dünne (<2.5nm) elektroneninjektionsfördernde Schicht aus einem Metall angeordnet ist.

18. Lichtemittierendes Bauelement nach einem der Ansprüche 1 bis 17, **dadurch gekennzeichnet, dass** die molare Konzentration der Beimischung in der Löchertransportschicht (3; 7a) und/oder in der Elektronentransportschicht (7; 3a) im Bereich 1:100.000 bis 1:10 bezogen auf das Verhältnis von Dotierungsmolekülen zu Hauptsubstanzmolekülen liegt.

19. Lichtemittierendes Bauelement nach einem der Ansprüche 1 bis 18 **dadurch gekennzeichnet, dass** eine jeweilige Schichtdicke der Löchertransportschicht (3; 7a), der Elektronentransportschicht (7; 3a), der mindestens einen lichtemittierenden Schicht (5; 5a) der löcherseitigen Blockschichten (4; 6a) und der elektronenseitigen Blockschicht (6; 4a) zwischen 0.1nm bis 50µm beträgt.

## Claims

1. A transparent, thermally stable light-emitting component having organic layers, in particular an organic light emitting diode, comprising an arrangement of layers including a transparent substrate (1) and two electrodes forming an anode (2; 8a) and a cathode (8; 2a), whereby said anode (2; 8a) is transparent, a hole transport layer (3; 7a), at least one light-emitting layer (5; 5a), and an electron transport layer (3; 7a) are formed between said two electrodes, and said hole transport layer (3; 7a) is p-doped with an acceptor-type organic material, **characterized in that** said cathode (8; 2a) is transparent and said electron transport layer (7;3a) is n-doped with a donor-type organic material, whereby a molecular mass of said acceptor-type organic material and a molecular mass of said donor-type organic material are greater than 200 g/mole.

2. A light-emitting component according to claim 1, **characterized in that** a hole-side blocking layer (4; 6a) is provided between said doped hole transport layer (3; 7a) and said light-emitting layer (5; 5a).

3. A light-emitting component according to claim 1 or 2, **characterized in that** an electron-side blocking layer (6; 4a) is provided between said doped electron transport layer (7; 3a) and said light-emitting layer (5; 5a).

4. A light-emitting component according to one of the claims 1 to 3, **characterized in that** said two transparent electrodes are of the same electrode type.

5. A light-emitting component according to one of the claims 1 to 4, **characterized in that** said two transparent electrodes consist of indium tin oxide (ITO).

6. A light-emitting component according to one of the claims 1 to 5, **characterized in that** said two transparent electrodes consist of a transparent material similar to ITO, namely of another degenerate oxide semiconductor.

7. A light-emitting component according to one of the claims 1 to 6, **characterized in that** said two transparent electrodes consist of different transparent contact materials.

8. A light-emitting component according to one of the claims 1 to 7, **characterized in that** a thin (<10nm) contact-improving layer, which can be readily tunneled through, is provided in each case between said electron transport layer (7; 3a) and the transparent cathode (8; 2a) and/or between the transparent anode (2; 8a) and the hole transport layer (3; 7a).

9. A light-emitting component according to one of the claims 1 to 8, **characterized in that** said light-emitting layer (5; 5a) is a mixed layer of several materials.

10. A light-emitting component according to one of the claims 1 to 9, **characterized in that** said hole transport layer (3; 7a) consists of an organic main substance and said acceptor-type organic material.

11. A light-emitting component according to one of the claims 1 to 10, **characterized in that** said electron transporting layer (7; 3a) consists of a mixture of an organic main substance and said donor-type organic material.

12. A light-emitting component according to one of the claims 1 to 11, **characterized in that** a top situated of said two transparent electrodes (8; 8a) is provided with a transparent protective layer (9).

13. A light-emitting component according to one of the claims 1 to 12, **characterized in that** said top situated transparent electrode (8; 8a) is provided with a very thin (<5nm) metallic intermediate layer to the subjacent electron / hole transport layer (7; 7a), so that the transparency in the entire visible spectral region is greater than 75%.

14. A light-emitting component according to one of the claims 1 to 13, **characterized in that** a bottom situated of said two transparent electrodes (2; 2a) is provided with a very thin (<5nm) metallic intermediate layer to the superjacent hole / electron transport layer (3; 3a), so that the transparency in the entire visible spectral region is greater than 75%.

15. A light-emitting component according to one of the claims 1 to 14, **characterized in that** an arrangement of said p-doped hole transport layer (3; 7a) and said transparent anode (2; 8a) is formed repeatedly.

16. A light-emitting component according to one of the claims 1 to 15, **characterized in that** an arrangement of said n-doped electron transport layer (7; 3a) and said transparent cathode (8; 2a) is formed repeatedly.

17. A light-emitting component according to one of the claims 1 to 16, **characterized in that** a thin (<2.5nm) electron-injection-promoting layer made of metal is provided between said electron transport layer (7; 3a) and said electron-side blocking layer (6; 4a) / said light-emitting layer (5; 5a).

18. A light-emitting component according to one of the claims 1 to 17, **characterized in that** the molar concentration of the admixture in said hole transport layer (3; 7a) and/or in said electron transport layer (7; 3 a) lies in the range of 1:100,000 to 1:10, calculated on the ratio of doping molecules to main-substance molecules.

19. A light-emitting component according to one of the claims 1 to 18, **characterized in that** a layer thickness of each of said hole transport layer (3; 7a), said electron transport layer (7; 3a), said at least one light-emitting layer (5; 5a), said hole-side blocking layer (4; 6a), and said electron-side blocking layer (6; 4a) lies in the range of 0.1 nm to 50 µm.

## Revendications

1. Composant luminescent transparent thermiquement stable pourvu de couches organiques, en particulier une diode électroluminescente organique, comprenant une disposition de couches avec un substrat transparent (1) et deux électrodes avec lesquelles une anode (2; 8a) et une cathode (8; 2a) sont constituées, l'anode (2; 8a) étant transparente, une couche de transport de trous (3; 7a), au moins une couche luminescente (5; 5a) et une couche de transport d'électrons (7; 3a) étant disposées entre les deux électrodes, et la couche de transport de trous (3; 7a) étant dopée P avec un matériau organique de type accepteur, **caractérisé en ce que** la cathode (8; 2a) est transparente, et que la couche de transport d'électrons (7; 3a) est dopée N avec un matériau organique de type donneur, une masse moléculaire du matériau organique de type accepteur et une masse moléculaire du matériau organique de type donneur étant supérieures à 200 g/mol.

2. Composant luminescent selon la revendication 1 **caractérisé en ce qu'**entre la couche dopée de transport de trous (3; 7a) et la couche luminescente (5; 5a) est prévue une couche barrière (4; 6a) du côté de la couche de transport de trous.

3. Composant luminescent selon la revendication 1 ou 2 **caractérisé en ce qu'**entre la couche dopée de transport d'électrons (7; 3a) et la couche luminescente (5; 5a) est prévue une couche barrière (6; 4a) du côté de la couche de transport d'électrons.

4. Composant luminescent selon l'une quelconque des revendications 1 à 3 **caractérisé en ce que** les deux électrodes transparentes sont du même type d'électrode.

5. Composant luminescent selon l'une quelconque des revendications 1 à 4 **caractérisé en ce que** les deux électrodes transparentes sont en oxyde d'indium et d'étain (ITO).

6. Composant luminescent selon l'une quelconque des revendications 1 à 5 **caractérisé en ce que** les deux électrodes transparentes sont en un matériau transparent analogue à l'ITO, à savoir un autre oxyde semi-conducteur dégénéré.

7. Composant luminescent selon l'une quelconque des revendications 1 à 6 **caractérisé en ce que** les deux électrodes transparentes sont en matériaux de jonction transparents différents.

8. Composant luminescent selon l'une quelconque des revendications 1 à 7 **caractérisé en ce qu'**entre la couche de transport d'électrons (7; 3a) et la cathode transparente (8; 2a), et/ou entre l'anode transparente (2; 8a) et la couche de transport de trous (3; 7a) est prévue une couche peu épaisse (< 10 nm) améliorant la jonction qui peut être facilement traversée par effet tunnel.

9. Composant luminescent selon l'une quelconque des revendications 1 à 8 **caractérisé en ce que** la couche luminescente (5; 5a) est une couche mixte constituée de plusieurs matériaux.

10. Composant luminescent selon l'une quelconque des revendications 1 à 9 **caractérisé en ce que** la couche de transport de trous (3; 7a) se compose d'une substance organique principale et du matériau organique de type accepteur.

11. Composant luminescent selon l'une quelconque des revendications 1 à 10 **caractérisé en ce que** la couche de transport d'électrons (7; 3a) se compose d'un mélange d'une substance organique principale et du matériau organique de type donneur.

12. Composant luminescent selon l'une quelconque des revendications 1 à 11 **caractérisé en ce que** celle des deux électrodes transparentes disposée sur le dessus (8; 8a) est munie d'une couche de protection transparente (9).

13. Composant luminescent selon l'une quelconque des revendications 1 à 12 **caractérisé en ce que** l'électrode transparente disposée sur le dessus (8; 8a) est munie d'une couche intermédiaire métallique très peu épaisse (< 5nm) par rapport à la couche de transport de trous et/ou d'électrons (7;7a) située au-dessous, de sorte que la transparence est supérieure à 75 % dans tout le domaine du spectre visible.

14. Composant luminescent selon l'une quelconque des revendications 1 à 13 **caractérisé en ce que** celle des deux électrodes transparentes disposée sur le dessous (2; 2a) est munie d'une couche intermédiaire métallique très peu épaisse (< 5nm) par rapport à la couche de transport de trous et/ou d'électrons (3; 3a) située au-dessus, de sorte que la transparence est supérieure à 75 % dans tout le domaine du spectre visible.

15. Composant luminescent selon l'une quelconque des revendications 1 à 14 **caractérisé en ce qu'**une disposition de la couche dopée P de transport de trous (3; 7a) et l'anode transparente (2; 8a) est établie plusieurs fois.

16. Composant luminescent selon l'une quelconque des revendications 1 à 15 **caractérisé en ce qu'**une disposition de la couche dopée N de transport d'électrons (7; 3a) et la cathode transparente (8; 2a) est établie plusieurs fois.

17. Composant luminescent selon l'une quelconque des revendications 1 à 16 **caractérisé en ce qu'**entre la couche de transport d'électrons (7; 3a) et la couche barrière (6; 4a) du côté de la couche de transport d'électrons / la couche luminescente (5; 5a) est disposée une couche peu épaisse (< 2,5 nm) de facilitation d'injection d'électrons constituée d'un métal.

18. Composant luminescent selon l'une quelconque des revendications 1 à 17 **caractérisé en ce que** la concentration molaire de l'impureté dans la couche de transport de trous (3; 7a) et/ou dans la couche de transport d'électrons (7; 3a) se situe dans le domaine de 1:100.000 jusqu'à 1:10 rapportée au rapport entre les molécules dopantes et les molécules de la substance principale.

19. Composant luminescent selon l'une quelconque des revendications 1 à 18 **caractérisé en ce que** les épaisseurs de couche respectives de la couche de transport de trous (3; 7a), de la couche de transport d'électrons (7; 3a), de la ou des couches luminescente (s) (5; 5a), des couches barrières du côté de la couche de transport de trous (4; 6a) et du côté de la couche de transport d'électrons (6; 4a) se situent entre 0,1 nm et 50 µm.
